# EUROPEAN PATENT SPECIFICATION

(11) **EP 1 401 064 B1**
(45) Date of publication and mention of the grant of the patent: **30.05.2007**
(21) Application number: 03013786.3
(22) Date of filing: 18.06.2003
(51) Int. Cl.: H01R 31/06, H01R 43/24

(54) **An adaptor for electrical connection between connectors having different numbers of poles**
Adaptor für elektrische Verbindungen zwischen Verbindern mit unterschiedlichen Polzahlen
Adaptateur pour la connexion électrique entre connecteurs à nombre de pôles différents.

(30) Priority: 02.09.2002 IT TO20020761
(43) Date of publication of application: 24.03.2004
(73) Proprietor: MENBER'S S.p.A., 37045 Legnago (Verona) (IT)
(72) Inventor: Pasotto, Giorgio, 37045 Legnago (Verona) (IT)
(74) Representative: Marchitelli, Mauro

(56) References cited:
- EP-A- 1 148 600
- US-A- 5 906 513

## Description

The present invention relates in general to devices for electrical connection between a tractor vehicle and a trailer. Generally, tractor vehicles and trailers are equipped with plugs and sockets that are complementary to one another and built in compliance with standards, for example according to ISO standards.

Frequently, there is the need to connect electrically together plugs and sockets having a different number of poles. In order to meet this need there have been developed adaptor devices having two connection sections designed to establish an electrical connection with a plug and a socket having different numbers of poles. The document EP1148600 filed in the name of the present applicant describes an adaptor according to the preamble of the main claim, comprising a contact-carrying body housed inside an external shell having two connector bodies designed for providing coupling with respective complementary connector bodies. The contact-carrying body of the adaptor described in EP1148600 comprises a printed-circuit board, to which are fixed a first set and a second set of contacts connected together by the conductive paths of the printed-circuit board. The printed-circuit board and the contacts are englobed in a body of co-moulded plastic material.

With the development of new-generation tractor vehicles and trailers, the number of electrical connection lines that it is necessary to provide between the tractor vehicle and the trailer has progressively increased. Consequently, in the last few years there have been developed electrical connectors with an increasingly greater number of poles. On the other hand, tractor vehicles must frequently be used with trailers of an older type, above all in the case of fleets of transport vehicles, in which exchange of the trailers and of the tractor vehicles is very frequent. Consequently, there is the need to ensure compatibility of the electrical connection between many types of connectors with a wide range of numbers of poles and sometimes made in compliance with different standards.

There has hence emerged on the market the concrete need to have available adaptor devices that will enable electrical connection of a relatively high number of electrical connectors that differ from one another, with all the possible combinations of the conditions of connection. Another equally important need is that of providing an adaptor which is compact and of limited overall dimensions.

The purpose of the present invention is to provide an adaptor for electrical connection between connectors having different numbers of poles, which will enable the aforesaid needs to be met.

According to the present invention, said purpose is achieved by an adaptor having the characteristics forming the subject of the ensuing claims.

The present invention will now be described in detail with reference to the attached drawings, which are provided purely by way of non-limiting example and in which:
- Figure 1 is a perspective view illustrating a printed-circuit board bearing a plurality of sets of contacts for an adaptor according to a first embodiment of the present invention;
- Figure 2 is a perspective view of the rear face of the printed-circuit board of Figure 1;
- Figure 3 is a perspective view of an adaptor according to a first embodiment of the present invention obtained after the step of co-moulding of plastic material;
- Figure 4 is a cross-sectional view according to the line IV-IV of Figure 3;
- Figure 5 is a perspective view of the rear face of the adaptor illustrated in Figure 3;
- Figures 6 and 7 are perspective views from a different angle of a second embodiment of an adaptor according to the present invention;
- Figure 8 is a perspective view of a printed-circuit board bearing a plurality of contacts, for the adaptor according to Figures 6 and 7; and
- Figure 9 is a cross-sectional view according to the line IX-IX of Figure 6.

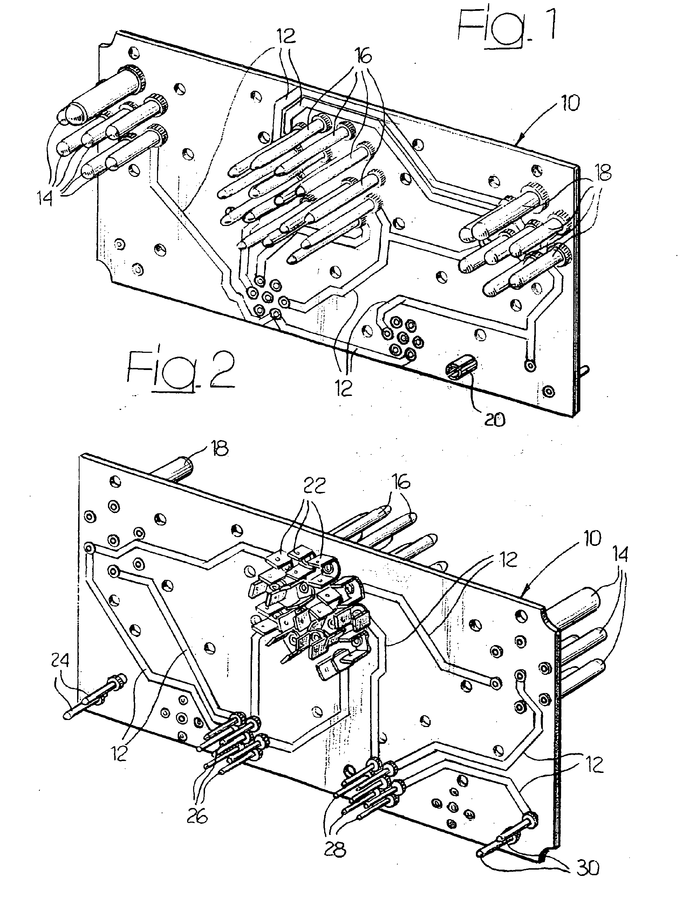

With reference to Figures 1 and 2, the reference number 10 designates a printed-circuit board consisting of a rigid plate of plastic material in which there are formed a plurality of conductive paths 12. A plurality of electrical contacts are fixed on both of the faces of the printed-circuit board 10. In the example illustrated in the figures, the electrical contacts are divided into a plurality of series or sets, designed to establish an electrical connection with the electrical contacts of a complementary connector. The sets of electrical contacts fixed on a first face of the printed-circuit board 10 are designated by 14, 16, 18 and 20. The electrical contacts fixed on the opposite face are designated by 22, 24, 26, 28 and 30. All of the contacts from 14 to 30 are fixed directly on the board 10. Each contact is electrically connected to a conductive path 12 or else to a contact set on the opposite face. The conductive paths 12 have the function of electrically connecting together the contacts fixed on the two opposite faces of the printed-circuit board 10. For example, each contact fixed on the first face of the printed-circuit board 10 may be electrically connected to just one or to two or more contacts fixed on the rear face of the board 10.

The way in which the contacts are fixed to the board 10 depends upon the type of contacts. In the case of pin contacts, fixing is obtained by inserting one end of each contact in a respective hole of the printed-circuit board 10. The end portion of the contact that projects from the opposite side of the printed-circuit board 10 is deformed plastically by means of riveting or upsetting, so providing a firm mechanical anchorage of the contact to the board 10. The contacts designated by 22 of the spade or Faston type are, instead, fixed to the board 10 by means of a riveted pin or else may be fixed directly on the end portion of a corresponding pin contact 16 set on the opposite face of the board 10. In the case in which the electrical contacts arranged on the opposite faces of the board 10 are directly connected together mechanically and electrically, it is evidently not necessary to provide electrical conductive paths for providing the electrical connection.

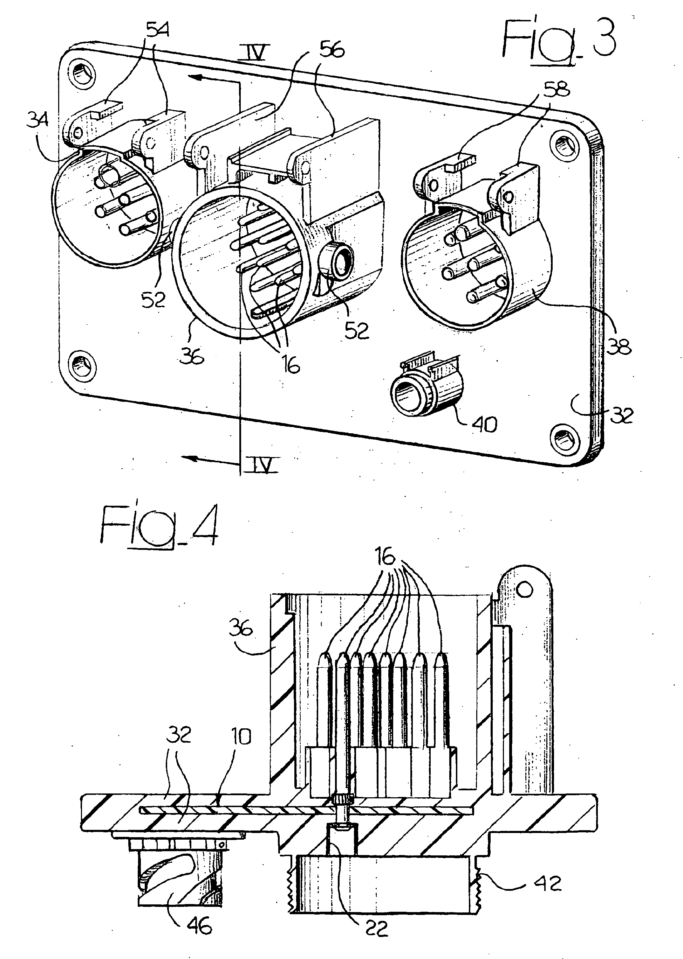

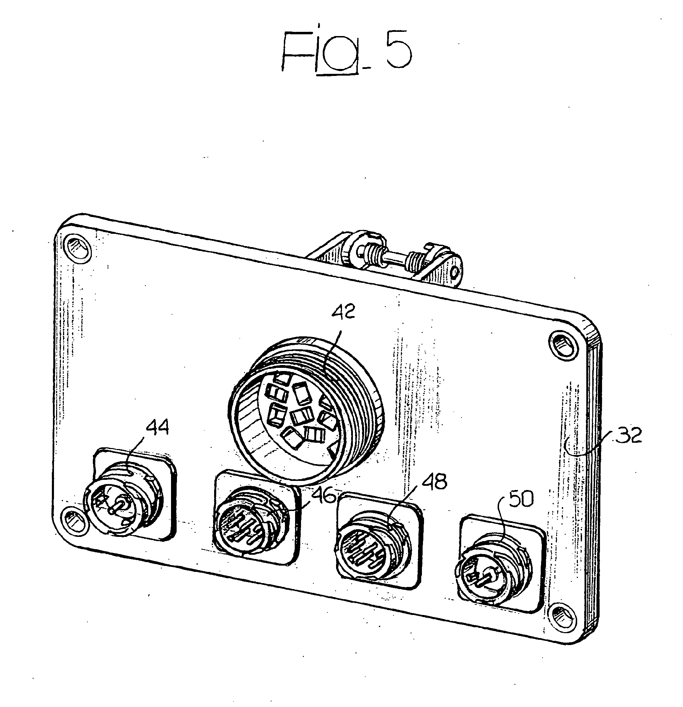

The printed-circuit board 10, with the corresponding electrical contacts, constitutes an independent pre-assembled contact-carrying unit with all the electrical connections necessary between the contacts of the different sets for providing different possibilities of electrical adaptation. The contact-carrying unit formed by the printed-circuit board 10 and by the contacts 14-30 is subsequently subjected to a co-moulding step. Co-moulding is performed by setting the contact-carrying unit in an injection mould, in which plastic material melted at high pressure that fills the moulding cavity and surrounds the printed-circuit board 10 is injected. The moulds in which injection of plastic material is carried out are shaped so that, at the end of the process of moulding, there is obtained a component having the shape illustrated in Figures 3, 4 and 5. In particular, during co-moulding a coating 32 of insulating material is formed, which coats both the faces of the printed-circuit board 10. A plurality of connector bodies 34, 36, 38 and 40 are formed on the front face of the adaptor device in a position corresponding to the sets of contacts 14, 16, 18 and 20 (see Figure 3), and a plurality of connector bodies 42, 44, 46, 48 and 50 are formed on the rear face of the adaptor (see Figure 5) in a position corresponding to the sets of contacts 22, 24, 26, 28 and 30. The connector bodies from 34 to 50 are formed in an integral and monolithic way with the coating 32 that coats the printed-circuit board 10. The connector bodies from 34 to 50 are shaped so as to couple to complementary connector bodies (not illustrated) and are equipped with the members designed to establish mechanical connection and fixing to the complementary connector bodies. For example, the connector body 36 is equipped with of a pair of seats 52 designed to receive a pair of metal pins (not illustrated), which have the function of engagement of a lever-type clamping member carried by the complementary connector body. The connector body 42 is equipped, on its external surface, with a thread whilst the connector bodies 44, 46, 48 and 50 are equipped, on the respective external surfaces, with bayonet-type engagement formations. The connector bodies will moreover be equipped with all the centring and guide surfaces necessary for the connection with the complementary connector bodies. In practice, at the end of the co-moulding process there is obtained a monolithic body made of plastic material, in which there is enclosed and firmly fixed the contact-carrying unit consisting of the printed-circuit board 10, to which the contacts are mechanically fixed. The parts of the contacts closest to the plate 10 are also coated with plastic material, for example in the form of collars that surround the respective contacts. The finished adaptor is extremely compact and sturdy and enables high versatility of electrical connection to be obtained between contacts of different types. For example, by providing, in an appropriate way, the electrical connections on the printed-circuit board 10, it will be possible to provide a wide range of possibilities of electrical connection between the connectors present on the front face and on the rear face of the adaptor.

The adaptor illustrated in Figures 3 and 5, is further completed with the addition of accessory components and members, such as, for example, doors for closing (not illustrated) articulated on walls 54, 56 and 58 formed in a monolithic way with the respective connector bodies.

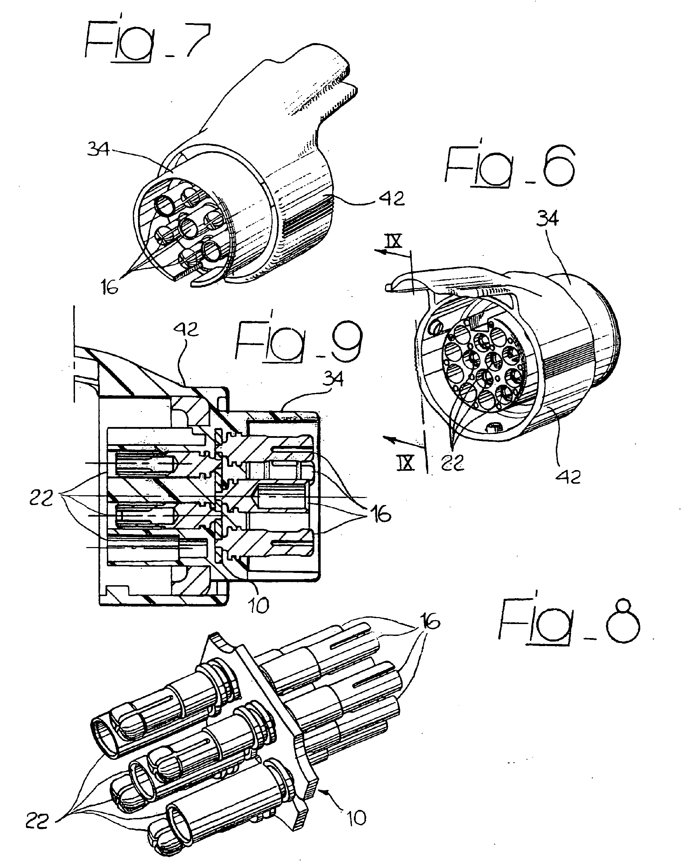

Figures 6, 7 and 9 illustrate a second embodiment of an adaptor according to the present invention. The elements corresponding to those previously described are designated by the same reference numbers. The above variant differs from the foregoing embodiment in that the adaptor presents just one set of contacts on one side and one set of contacts on the opposite side. With reference to Figure 8, the contact-holder unit comprises a board 10 bearing the two sets of contacts, designated by 16 and 22, fixed on the opposite sides of the board 10 and electrically connected together. The contact-holder unit including the board 10 and the sets of contacts 16, 22 is subjected to an operation of co-moulding in a way similar to what has been described previously. During said co-moulding process there is formed an external shell that englobes the board 10 and the sets of contacts 16, 22. The external shell defines two connector bodies designated by 34 and 42, which are fixed with respect to the board 10 and to the contacts 16, 22. The connector bodies 34, 42 are shaped so as to enable coupling with complementary connector bodies.

Of course, without prejudice to the principle of the invention, the details of construction and the embodiments may vary widely with respect to what is described and illustrated herein purely by way of example, without thereby departing from the scope of the present invention as defined by the ensuing claims. For example, the shape and the dimensions of the connector bodies may vary widely, as well as the number of the connector bodies provided on each side of the printed-circuit board and the number of contacts provided for each connector body.

## Claims

1. An adaptor for electrical connection between connectors having different numbers of poles, comprising:
- an external shell with a first and a second section having at least one first and one second connector body (34, 36, 38, 40; 42, 44, 46, 48, 50) designed to establish a connection with complementary connector bodies;
- a printed-circuit board (10); and
- at least one first and one second series of contacts (14, 16, 18, 20; 22, 24, 26, 28, 30) fixed on a first and on a second face of said board (10) and electrically connected together,
**characterized in that** said external shell with said connector bodies (34, 36, 38, 40; 44, 46, 48, 50) is co-moulded on said board (10), the connector bodies (34, 36, 38, 40; 44, 46, 48, 50) being formed in an integral and monolithic way with a coating (32) that coats the printed-circuit board (10) and being equipped with integral members designed to establish mechanical connection and fixing to the complementary connector bodies.

2. The adaptor according to Claim 1, **characterized in that** it comprises a plurality of connector bodies (54, 56, 58, 40; 42, 44, 46, 48, 50) on each face of said board (10).

3. The adaptor according to Claim 1, **characterized in that** it comprises a single set of contacts (16) on a first side of the contact board (10) and a single set of contacts (22) on the opposite side.

## Patentansprüche

1. Adapter zur elektrischen Verbindung zwischen Verbindern mit unterschiedlicher Anzahl von Polen, der umfasst:
ein äußeres Gehäuse mit einem ersten und einem zweiten Abschnitt, das wenigstens einen ersten und einen zweiten Verbinder-Körper (34, 36, 38, 40; 42, 44, 46, 48, 50) hat, die dazu dienen, eine Verbindung mit komplementären Verbinder-Körpern herzustellen;
eine Leiterplatte (10); und
wenigstens eine erste sowie eine zweite Reihe von Kontakten (14, 16, 18, 20; 22, 24, 26, 28, 30), die an einer ersten und einer zweiten Fläche der Platte (10) befestigt und elektrisch miteinander verbunden sind,
**dadurch gekennzeichnet, dass** das äußere Gehäuse mit den Verbinder-Körpern (34, 36, 38, 40; 44, 46, 48, 50) zusammen auf die Platte (10) geformt ist, wobei die Verbinder-Körper (34, 36, 38, 40; 44, 46, 48, 50) integral und aus einem Stück mit einem Überzug (32) ausgebildet sind, der die Leiterplatte (10) überzieht, und mit integralen Elementen versehen sind, die dazu dienen, mechanische Verbindung mit und Befestigung an den komplementären Verbinder-Körpern herzustellen.

2. Adapter nach Anspruch 1, **dadurch gekennzeichnet, dass** er eine Vielzahl von Verbinder-Körpern (54, 56, 58, 40; 42, 44, 46, 48, 50) an jeder Fläche der Platte (10) umfasst.

3. Adapter nach Anspruch 1, **dadurch gekennzeichnet, dass** er eine einzelne Gruppe von Kontakten (16) an einer ersten Seite der Kontaktplatte (10) und eine einzelne Gruppe von Kontakten (22) an der gegenüberliegenden Seite umfasst.

## Revendications

1. Adaptateur pour la connexion électrique entre des connecteurs avec nombres de pôles différents, comprenant:
- une enveloppe extérieure avec une première et une deuxième section ayant au moins un premier et un deuxième corps de connecteur (34, 36, 38, 40; 42, 44, 46, 48, 50) conçus pour établir une connexion avec des corps de connecteur complémentaires ;
- une carte de circuits imprimés (10); et
- au moins une première et une deuxième séries de contacts (14, 16, 18, 20; 22, 24, 26, 28, 30) fixés sur une première et une deuxième face de ladite carte (10) et connectés électriquement entre eux,
**caractérisé en ce que** ladite enveloppe extérieure avec lesdits corps de connecteur (34, 36, 38, 40; 44, 46, 48, 50) est moulée conjointement sur ladite plaque (10), les corps de connecteur (34, 36, 38, 40; 44, 46, 48, 50) étant formés d'une manière intégrale et monolithe avec un revêtement (32) qui recouvre la carte de circuits imprimés (10) et étant équipés d'éléments intégraux conçus pour établir une connexion et fixation mécanique avec les corps de connecteur complémentaires.

2. Adaptateur selon la revendication 1, **caractérisé en ce qu'**il comprend une pluralité de corps de connecteur (54, 56, 58, 40; 42, 44, 46, 48, 50) sur chaque face de ladite carte (10).

3. Adaptateur selon la revendication 1, **caractérisé en ce qu'**il comprend un unique groupe de contacts (16) sur un premier côté de la carte de contacts (10) et un unique groupe de contacts (22) sur le côté opposé.
